## Europäisches Patentamt
## European Patent Office
## Office européen des brevets

(11) Veröffentlichungsnummer: **0 030 387**
A2

# EUROPÄISCHE PATENTANMELDUNG

(21) Anmeldenummer: 80107727.2

(22) Anmeldetag: 08.12.80

(51) Int. Cl.³: **G 01 R 13/40**, G 02 F 1/133

(30) Priorität: 10.12.79 DE 2949561

(43) Veröffentlichungstag der Anmeldung: **17.06.81** Patentblatt 81/24

(84) Benannte Vertragsstaaten: **FR GB IT**

(71) Anmelder: **SIEMENS AKTIENGESELLSCHAFT Berlin und München, Postfach 22 02 61, D-8000 München 22 (DE)**

(72) Erfinder: **Walter, Karl-Heinz, Dipl.-Ing., Herzog-Heinrich-Strasse 13, D-8018 Grafing (DE)**

(54) **Analoge Spannungsanzeige mit Flüssigkristallen.**

(57) Die Erfindung betrifft eine analoge Spannungsanzeige mit Flüssigkristallen. Die Flüssigkristallanzeige weist eine der Zahl der Anzeigeschritte entsprechende Zahl von Elektroden (4) auf. Eine Elektrode überlappt jeweils zwei Gegenelektroden (5). Die Grösse der Elektroden bzw. der Überlappung (9) nimmt beginnend mit der niedrigsten Anzeige nach einer geometrischen Reihe zu. Die Elektroden sind über das Flüssigkristall kapazitiv gekoppelt, die beiden äusseren sind an die anzuzeigende Spannung ($U_x$) anschliessbar. Die Erfindung ist zum Beispiel bei Hochspannungsprüfer anwendbar.

0030387

SIEMENS AKTIENGESELLSCHAFT          Unser Zeichen
Berlin und München                  VPA 79 P 1 1 9 2 EUR

## Analoge Spannungsanzeige mit Flüssigkristallen

Die Anmeldung bezieht sich auf eine analoge Spannungsanzeige mit Flüssigkristallen, bei der der Flüssigkristall (FK) zwischen zwei durchsichtigen Scheiben eingeschlossen ist, die innen mit durchsichtigen, Anzeigesegmente bildenden, nebeneinanderliegenden Elektroden versehen sind, wobei die Elektroden beider Scheiben sich gegenüberliegen.

Eine solche analoge Spannungsanzeige ist zum Beispiel in der DE-OS 28 28 432 beschrieben worden. Die auf einer der Scheiben angeordneten Elektroden sind durch ein Widerstandsnetzwerk miteinander gekoppelt, das so dimensioniert ist, daß für eine bestimmte anzuzeigende Spannung eine bestimmte Anzahl hintereinanderliegender Anzeigesegmente anspricht. Das Widerstandsnetzwerk wird dabei von einem Strom durchflossen, so daß eine leistungslose Spannungsmessung nicht möglich ist.

Hab 1 Dx / 07.12.1979

Der Erfindung liegt die Aufgabe zugrunde, eine analoge Spannungsanzeige der eingangs erwähnten Art so weiterzubilden, daß eine zumindest leistungsarme Spannungsmessung möglich ist.

Diese Aufgabe wird dadurch gelöst, daß die Elektroden elektrisch voneinander getrennt sind, daß die einander gegenüberliegenden Elektroden so gegeneinander versetzt sind, daß jeweils eine auf einer der Scheiben angeordnete Elektrode zwei der gegenüberliegenden Elektroden überlappt und die überlappende Fläche das Anzeigesegment bildet, daß die Flächen der nebeneinanderliegenden Elektroden, beginnend mit dem Anzeigesegment für den niedrigsten Spannungswert, derart anwachsen, daß die Anzeigesegmente der Bedingung

$$\varkappa\, \eta\, c_\nu = c_{\nu+1}$$

genügen, wobei $c_\nu$ die Kapazität des Anzeigesegmentes $\nu$, $\eta$ die relative Erhöhung der Dielektrizitätskonstante des FK bei Übergang vom nichtanzeigenden zum anzeigenden Zustand und $\varkappa$ eine von der Steilheit der elektrooptischen Kennlinie des FK abhängige Zahl ist, die zwischen 1,1 und 1,5 liegt, und daß die am Anfang und Ende der Anzeige liegenden Elektroden an die anzuzeigende Spannung anschließbar sind.

Weiterbildungen der Erfindung sind Gegenstand der Unteransprüche.

Die Erfindung wird an Hand einiger Ausführungsbeispiele in Verbindung mit den Fig. 1 bis 5 näher erläutert. Es zeigen:

Fig. 1 den Schnitt durch ein erstes Ausführungsbeispiel,
Fig. 2 den Schnitt durch ein zweites Ausführungsbeispiel,

Fig. 3 die Aufsicht auf das zweite Ausführungsbeispiel,
Fig. 4 die Aufsicht auf ein viertes Ausführungsbeispiel
     und
Fig. 5 die Aufsicht auf ein fünftes Ausführungsbeispiel
     der Erfindung.

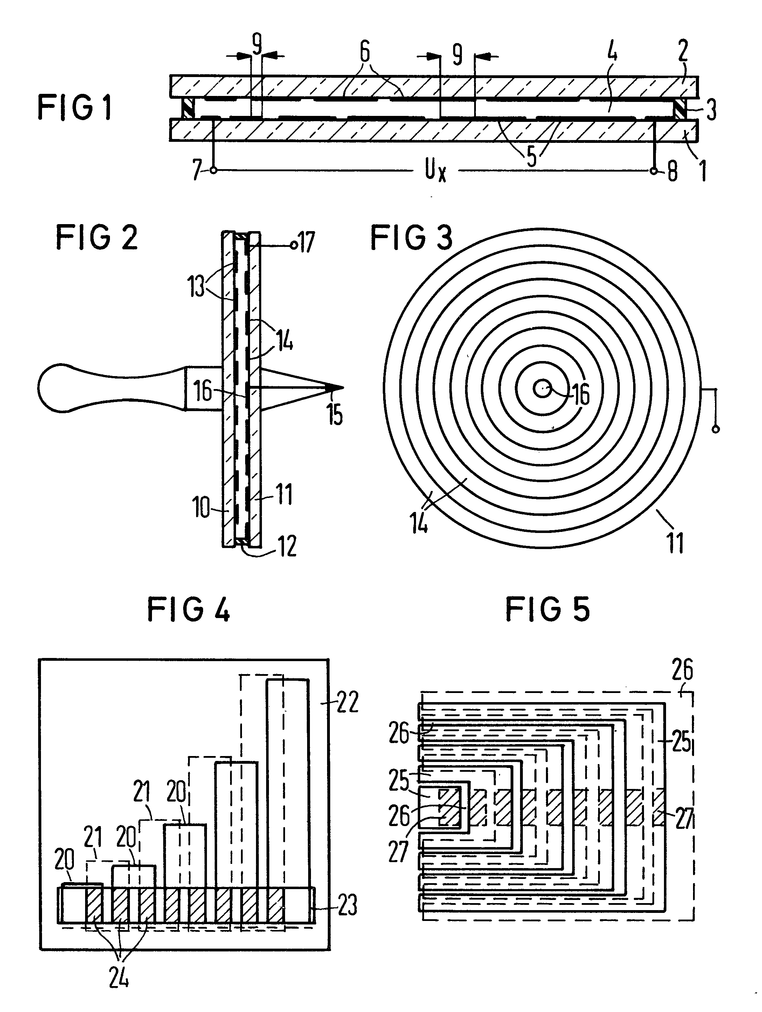

Die Flüssigkristallanzeige nach Fig. 1 weist zwei durchsichtige Platten 1 und 2 auf, die durch einen Rahmen 3 miteinander verbunden sind. Der dadurch gebildete Raum wird von einem Flüssigkristall (FK) 4 ausgefüllt. Die Scheiben 1, 2 sind mit durchsichtigen Elektroden 5 beziehungsweise Gegenelektroden 6 versehen. Die Elektroden 5 liegen den Gegenelektroden 6 derart gegenüber, daß zwei der nebeneinanderliegenden Elektroden beziehungsweise Gegenelektroden von einer auf der anderen Scheibe angebrachten Gegenelektrode beziehungsweise Elektrode überlappt werden. Die überlappenden Flächen bilden Anzeigesegmente 9. Die Elektroden 5 und die Gegenelektroden 6 wachsen in ihrer Fläche von links nach rechts, was in Fig. 1 durch zunehmende Breite dargestellt ist. Dementsprechend wächst auch die Breite der Anzeigesegmente 9 von links nach rechts. Die Elektroden und Gegenelektroden sind miteinander lediglich kapazitiv gekoppelt, die beiden äußeren Elektroden sind über Anschlüsse 7, 8 an die anzuzeigende Spannung $U_x$ anschließbar.

Die Elektroden und die Gegenelektroden bilden Kondensatoren, deren Größe der Größe der überlappenden Flächen proportional ist. An der Spannung $U_x$ liegt demnach eine Kondensatorkette. Bei dieser müssen die einzelnen Kondensatoren so dimensioniert werden, daß das Anzeigesegment $D+1$ dann einschaltet, wenn die Spannung um einen bestimmten Betrag angestiegen ist. Da die Inkremente der Spannungsanzeige aus Gründen der Ablesbarkeit zweckmäßigerweise gleich sein sollten, bedeutet das, daß die Kapazität der Kondensatoren zu größeren Spannung hin anwachsen muß. Dabei ist zu berücksichtigen, daß ein FK im anzeigenden Zustand entsprechend der Anisotropie der Dielektrizitätskonstante eine um den Faktor $\eta$ größere Kapazität als im nichtanzeigenden Zustand hat. Da ein FK bei Anlegen einer Spannung nicht schlagartig anzeigt, sondern der Verlauf des Kontrastes über der Spannung entsprechend der Steilheit der elektrooptischen Kennlinie eine endliche Steilheit aufweist, ist bei der Dimensionierung der Kondensatoren ein Sicherheitsabstand $\varkappa$ zu berücksichtigen.

Bei Berücksichtigung der genannten Faktoren ergibt sich dann für das Verhältnis zweier aufeinanderfolgender Kapazitäten:

$$c_{\nu+1} = \eta \cdot \varkappa \cdot c_\nu.$$

Für m hintereinandergeschaltete Kondensatoren, das heißt Anzeigesegmente, von denen n ansprechen, gilt dann:

$$\frac{1}{c_{ges}} = \frac{1}{\eta c_1} + \frac{1}{\eta^2 \varkappa c_1} + \ldots + \frac{1}{\eta^n \varkappa^{n-1} c_1} +$$

$$\frac{1}{\eta^n \varkappa^n c_1} + \frac{1}{\eta^{n+1} \varkappa^{n+1} c_1} + \ldots + \frac{1}{\eta^{m-1} \varkappa^{m-1} c_1}.$$

0030387

Durch Summation dieser geometrischen Reihe ergibt sich:

$$\frac{1}{C_{ges}} = \frac{\varkappa}{c_1} \sum_{\nu=1}^{n} \left(\frac{1}{\eta\varkappa}\right)^\nu + \frac{\eta\varkappa}{c_1} \sum_{\nu=n+1}^{m} \left(\frac{1}{\eta\varkappa}\right)^\nu$$

$$= \frac{\varkappa}{c_1}(\eta\varkappa)^n \cdot \frac{1-(\eta\varkappa)^n}{1-\eta\varkappa} + \frac{\eta\varkappa}{c_1}(\eta\varkappa)^m \frac{1-(\eta\varkappa)^{m-(n-1)}}{1-\eta\varkappa}$$

Die Spannung an den ansprechenden Elementen ergibt sich dann aus:

$$\frac{U_{mess}}{U_{Anz}} = \frac{C_{Anz}}{C_{ges}} = 1 + \eta\frac{1-(\eta\varkappa)^{m-n}}{1-(\eta\varkappa)^n}$$

Will man eine kleinste Spannung gerade im ersten Segment zur Anzeige bringen, so muß sein

$$U_1 = U_{Schwelle\ FK.}$$

Die an die Kondensatorkette anzulegende Spannung muß entsprechend größer sein:

$$\frac{U_{mess}}{U_{Anz}} = 1 + \eta \cdot \frac{1-(\eta\varkappa)^{m-1}}{1-\eta\varkappa}$$

Aus der oben genannten Formel für $U_{ges}$ ergibt sich, daß die Kapazitäten beziehungsweise die Flächen der Anzeigesegmente nach einer geometrischen Reihe anwachsen. Im Fall des Ausführungsbeispiels nach Fig. 1 heißt dies, daß die Breiten der Anzeigesegmente ebenfalls nach einer geometrischen Reihe wachsen müssen. Dies führt beim Ausführungsbeispiel nach Fig. 1 zu einer nichtlinearen Anzeige für gleiche Inkremente der Spannung.

0030387

Vorteilhaft ist eine Ausführungsform, die in Fig. 2 und 3 dargestellt ist. Die analoge Spannungsanzeige besteht aus zwei kreisrunden, durchsichtigen, über einen Rahmen 12 verbundenen Platten 10, 11, auf denen ringörmige,

durchsichtige Elektroden 13 beziehungsweise Gegenelektroden 14 aufgebracht sind. Die Elektroden 13 und Gegenelektroden 14 überlappen sich dabei wie in Verbindung mit Fig. 1 beschrieben. Die Längen der Elektroden 13 und Gegenelektroden 14 wachsen dabei von innen nach außen nach einer geometrischen Reihe, so daß für nach einer geometrischen Reihe anwachsende Flächen die Breite der Elektroden, der Gegenelektroden und der Anzeigesegmente gleich gewählt werden kann. Damit ergibt sich eine lineare Anzeige der Spannung. Die Spannungsanzeige kann beispielsweise mit einem Handgriff versehen sein, der am Ende eine Meßspitze 15 trägt. Diese Meßspitze ist mit der innenliegenden, zentrisch angeordneten Gegenelektrode 16 verbunden. Die äußere Gegenelektrode ist mit einem Anschluß 17 verbunden. Die anzuzeigende Spannung wird dann zwischen die Meßspitze 15 und den Anschluß 17 gelegt.

In Fig. 4 ist eine analoge Spannungsanzeige dargestellt, bei der der Flächenzuwachs der Elektroden durch zunehmende Länge der Elektroden und der Gegenelektroden realisiert ist. Um eine übersichtliche Anzeige zu erhalten, ist die Anordnung mit einer Maske 22 bedeckt, die ein ein lineares Anzeigeband konstanter Breite freilassendes Fenster 23 aufweist. Die Elektroden sind hier mit 20 und die Gegenelektroden sind mit 21 bezeichnet. Die Anzeigesegmente 24 werden dann durch die überlappenden Flächen zwischen den Elektroden 20 und den Elektroden 21 gebildet und durch das Fenster 23 begrenzt.

Eine platzsparende Version ist in Fig. 5 dargestellt, bei der die Elektroden 25 bis auf die für den niedrigsten Spannungswert und die Gegenelektroden 26 U-förmig ausgeführt sind. Die Elektroden und die Gegenelektroden sind dabei ineinander verschachtelt. Die Anzeigesegmente werden wieder durch die überlappenden Flächen von Elektroden und Gegenelektroden gebildet. Zur Erzielung einer linearen Anzeige wird zweckmäßigerweise wiederum eine ein Fenster aufweisende Maske auf die Anordnung gelegt. Diese Maske wurde hier jedoch der besseren Übersichtlichkeit halber nicht dargestellt. Es ergeben sich dann Anzeigesegmente, die der besseren Übersichtlichkeit wegen schraffiert und mit 27 bezeichnet sind. Ebenfalls der besseren Übersichtlichkeit halber sind hier die Elektroden 25 durchgezogen und die Gegenelektroden 26 gestrichelt gezeichnet.

Als Flüssigkristall werden zweckmäßigerweise Stoffe verwendet, die je nach Verwendungszweck eine niedrige oder relativ hohe Schwellspannung haben. Für Hochspannungsanwendungen kommt zum Beispiel das FK ZLI 1085 der Firma Merck in Frage. Im allgemeinen empfehlen sich FK mit geringer dielektrischer Anisoptropie. Für die Anzeige selbst können alle bekannten elektrooptischen Effekte wie "dynamische Streuung", "Drehzelleneffekt", "DAP-Effekt", "Freedriks Effekt" und auch der "Phase-Change-Effekt" mit den gültigen Einschränkungen ausgenutzt werden.

5 Figuren
5 Patentansprüche

0030387

Patentansprüche

1. Analoge Spannungsanzeige mit Flüssigkristallen, bei der der Flüssigkristall (FK) zwischen zwei durchsichtigen Scheiben eingeschlossen ist, die innen mit durchsichtigen, Anzeigesegmente bildenden, nebeneinanderliegenden Elektroden versehen sind, wobei die Elektroden beider Scheiben sich gegenüberliegen, d a d u r c h g e k e n n z e i c h n e t , daß die Elektroden (5, 6; 13, 14; 20, 21; 25, 26) elektrisch voneinander getrennt sind, daß die einander gegenüberliegenden Elektroden so gegeneinander versetzt sind, daß jeweils eine auf einer der Scheiben (1, 2; 10, 11) angeordnete Elektrode (5, 13) zwei der gegenüberliegenden Elektroden (6, 14) überlappt und die überlappende Fläche das Anzeigesegment bildet, daß die Flächen der nebeneinanderliegenden Elektroden, beginnend mit dem Anzeigesegment für den niedrigsten Spannungswert, derart anwachsen, daß die Anzeigesegmente der Bedingung

$$\varkappa\, \eta\, c_\nu = c_{\nu+1}$$

genügen, wobei $c_\nu$ die Kapazität des Anzeigesegmentes $\nu$, $\eta$ die relative Erhöhung der Dielektrizitätskonstante des FK bei Übergang vom nichtanzeigenden zum anzeigenden Zustand und $\varkappa$ eine von der Steilheit der elektrooptischen Kennlinie des FK abhängige Zahl ist, die zwischen 1,1 und 1,5 liegt, und daß die am Anfang und Ende der Anzeige liegenden Elektroden an die anzuzeigende Spannung ($U_x$) anschließbar sind.

2. Spannungsanzeige nach Anspruch 1, d a d u r c h g e k e n n z e i c h n e t , daß die Elektroden (20, 21) jeweils gleiche Breite haben und daß ihre Länge entsprechend der Zunahme der Kapazität beginnend mit dem Anzeigesegment für den niedrigsten Spannungswert anwächst.

3. Spannungsanzeige nach Anspruch 2, g e k e n n - z e i c h n e t   d u r c h  eine mit einem Sichtfenster (23) versehene, Teile der Anzeigesegmente (24) bedeckende Maske (22), die ein lineares Anzeigeband konstanter Breite frei läßt.

4. Spannungsanzeige nach Anspruch 1, d a d u r c h g e k e n n z e i c h n e t ,  daß die Elektroden (25, 26) U-förmig ausgebildet und ineinander verschachtelt sind, daß die Joche der U-förmigen Elektroden gleiche Breite haben, und daß eine die Schenkel der Elektroden bedeckende Maske vorgesehen ist, die ein die Joche freilassendes Anzeigefenster konstanter Breite aufweist.

5. Spannungsanzeige nach Anspruch 1 oder 2, g e - k e n n z e i c h n e t   d u r c h  eine konzentrische Anordnung aller Elektroden (13, 14) und Anzeigesegmente zueinander.

0030387

1/1

FIG 1

FIG 2

FIG 3

FIG 4

FIG 5